# FASCICULE DE BREVET EUROPEEN

(11) **EP 0 497 651 B1**
(45) Date de publication et mention de la délivrance du brevet: **02.11.1994**
(21) Numéro de dépôt: 92400135.7
(22) Date de dépôt: 20.01.1992
(51) Int. Cl.: C23C 14/50, G02C 13/00

(54) **Support individuel retournable pour application d'un traitement à un quelconque substrat, en particulier un verre de lunettes, et matériel propre à la mise en oeuvre d'un tel support**
Einzelner wendbarer Halter zur Behandlung eines Substrats, insbesondere eines Brillenglases, sowie Anlage zur Anwendung eines solchen Halters
Individual, reversible support for the treatment of a substrate, in particular a spectacle lens, and equipment using such a support

(30) Priorité: 22.01.1991 FR 9100665
(43) Date de publication de la demande: 05.08.1992
(73) Titulaire: ESSILOR INTERNATIONAL Compagnie Générale d'Optique, F-94028 Créteil Cédex (FR)
(72) Inventeur: Stammler, Daniel, F-55310 Tronville-en-Barrois (FR); Beinat, Olivier, F-55000 Bar-le-Duc (FR)
(74) Mandataire: CABINET BONNET-THIRION

(56) Documents cités:
- EP-A- 0 406 484
- US-A- 2 532 971

## Description

La présente invention concerne d'une manière générale les substrats de contour périphérique globalement circulaire à l'une et l'autre des faces duquel doit être successivement appliqué un quelconque traitement.

C'est le cas, par exemple, des verres de lunettes auxquels doit être appliqué un traitement antireflet lorsque ce traitement antireflet est pratiqué avant leur débordage et leur biseautage.

Ainsi qu'on le sait, l'exécution de ce traitement antireflet implique de soumettre ces verres de lunettes à un bombardement électronique sous vide dans une enceinte appropriée à cet effet.

Pour ce faire, ils sont disposés en groupe sur un support collectif qui, pour des raisons pratiques, est en forme générale de calotte sphérique.

L'un des problèmes à résoudre dans la conduite d'un tel traitement tient à ce qu'il convient, à un moment donné, d'assurer le retournement des verres de lunettes, pour que le traitement qui leur est appliqué intéresse successivement, comme recherché, l'une et l'autre de leurs faces.

Dans la demande de brevet français qui, déposée sous le No 87 07816 le 4 Juin 1987, a été publiée sous le No 2.602.244, il est proposé, pour ce faire, de fractionner en secteurs le support collectif mis en oeuvre, et de faire pivoter sur eux-mêmes le moment venu chacun de ces secteurs, en les dotant à cet effet d'un dispositif de retournement approprié.

Mais, en pratique, la manipulation de ces secteurs est malaisée et périlleuse.

En outre, les supports individuels dont ils sont dotés pour le maintien, dans des ouvertures, des verres de lunettes à traiter, qu'il s'agisse de supports individuels fixes ou qu'il s'agisse de supports individuels montés pivotants pour permettre de donner une certaine orientation aux verres de lunettes, sont peu sûrs, ils empiètent de manière notable, au moins dans certains cas, sur la surface de l'une et de l'autre des faces à traiter, en conduisant à la formation d'une "marge" dépourvue de tout traitement sur celles-ci, et, comportant, dans d'autres cas, des pièces mobiles susceptibles de nécessiter une certaine lubrification, ils peuvent, sous vide, être à l'origine d'un dégazage intempestif.

En outre, ils ne conviennent pas nécessairement à tous les diamètres.

Dans la demande de brevet français qui, déposée sous le No 85 07778 le 23 Mai 1985, a été publiée sous le No 2.566.433, il a été proposé la mise en oeuvre d'un support cruciforme propre au maintien simultané de quatre verres de lunettes à traiter, et, pour le retournement nécessaire, ce support cruciforme est en pratique destiné à être monté pivotant sur un support collectif fixe.

Mais si un tel support cruciforme est à la rigueur bien adapté au maintien de verres de lunettes déjà débordés et biseautés, parce que ses branches fixes comportent des rainures, formant drageoir, dans lesquelles s'engagent leurs biseaux et qu'il suffit dès lors d'une simple languette élastiquement déformable les appliquant par leur tranche contre celles-ci, il n'en est évidemment pas de même pour des verres de lunettes non débordés et non biseautés.

En outre, les languettes élastiquement déformables mises en oeuvre ont en section un profil de rainure, et elles conduisent aussi de ce fait à la formation d'une marge, fût-ce limitée, sur l'une et l'autre des faces des verres de lunettes traités.

Dans d'autres installations à support collectif fixe également connues à ce jour, il est proposé la mise en oeuvre de supports individuels retournables formés d'une structure annulaire, qui, pour son montage pivotant sur le support collectif, est équipée extérieurement de tourillons, et qui, pour permettre d'y rapporter un verre de lunettes, est conjointement équipée de moyens d'assujettissement propres au maintien de celui-ci.

En pratique, ces moyens d'assujettissement comportent, d'une part, des jambages crantés, qui, répartis circulairement autour de l'axe de la structure annulaire, à la périphérie extérieure de celle-ci, s'étendent parallèlement à cet axe, et, d'autre part, un anneau élastique fendu, qui, venant en prise avec ces jambages par sa périphérie externe, applique, par son plan, contre la structure annulaire, le verre de lunettes à traiter.

Mais un tel support individuel n'est adapté qu'à un diamètre donné de verres de lunettes à traiter, et, au détriment des coûts, il faut donc disposer d'autant de supports individuels différents qu'il y a de verres de lunettes de diamètres différents à prendre en considération.

En outre, la partie périphérique de l'une et l'autre des faces de ces verres de lunettes échappe en totalité au traitement concerné, et la marge correspondante y est particulièrement importante.

La présente invention a tout d'abord pour objet un support individuel retournable avantageusement exempt de ces inconvénients.

Ce support individuel, qui, comme précédemment, est destiné à permettre de rapporter, sur un autre support, en pratique un support collectif, un quelconque substrat de contour périphérique globalement circulaire, et par exemple un verre de lunettes, à l'une et l'autre des faces duquel doit être successivement appliqué un quelconque traitement, est du genre comportant, d'une part, une structure annulaire, dite ci-après structure annulaire externe, qui, pour son montage pivotant sur le support collectif, est équipé extérieurement de tourillons, et, d'autre part, des moyens d'assujettissement propres à permettre de rapporter sur cette structure annulaire le substrat à traiter, et est d'une manière générale caractérisé en ce que lesdits moyens d'assujettissement comportent, d'une part, une bague, dite ci-après bague interne, qui, globalement concentrique de la structure annulaire, à l'intérieur de celle-ci, est propre à recevoir intérieurement le substrat à traiter, et, d'autre part, au moins deux languettes élastiquement déformables, qui, établies entre cette bague interne et la structure annulaire externe, sont propres à son maintien dans cette dernière.

Ainsi, seule la bague interne doit être adaptée au diamètre du substrat à traiter, tandis que, indifférente à ce diamètre, la structure annulaire externe peut avantageusement être la même quel que soit celui-ci, au bénéfice du prix de revient des fabrications, et donc du traitement.

En pratique, la bague interne est préférentiellement ouverte radialement par une fente.

Elle peut ainsi avantageusement s'adapter aux inévitables tolérances de fabrication d'un substrat à un autre.

En outre, et surtout, cela lui permet, pour le maintien d'un substrat, d'intervenir par simple élasticité sur la tranche de ce substrat, et, donc, de retenir sans autre moyen d'assujettissement celui-ci quelle que soit la position, retournée ou non, du support individuel qu'elle équipe.

L'une et l'autre des faces du substrat se trouvent ainsi, pour l'essentiel, totalement dégagées, et il se prête donc pour l'essentiel au traitement correspondant sur la totalité de leur surface, sans la formation d'une marge substantielle sur celle-ci.

Certes, la bague interne du support individuel suivant l'invention présente cependant, radialement en saillie sur sa surface interne, un épaulement.

Mais cet épaulement, dont, radialement, l'extension est minime, et dont il ne résulte également la formation que d'une marge minimale sur la face correspondante du substrat, n'intervient pas dans la retenue de celui-ci.

Il a pour simple but d'en assurer un positionnement déterminé dans la bague interne.

En outre, cet épaulement appartenant en pratique à un retour en équerre de cette bague interne, la surface externe de cet épaulement est préférentiellement biseautée, ce qui en minimise encore avantageusement l'incidence sur le traitement pratiqué, en réduisant le volume mort interposé sur le rayonnement correspondant.

En bref, le support individuel retournable suivant l'invention permet avantageusement de traiter des substrats quel que soit leur diamètre et quelle que soit leur épaisseur, sans conduire à la formation d'une marge notable à la périphérie de l'une et l'autre de leurs faces.

En outre, il ne comporte avantageusement aucune pièce, et en particulier aucune vis, susceptible de conduire à un dégazage lors de la mise sous vide de ces substrats.

Enfin, il est avantageusement susceptible d'un montage facile et sûr sur le support collectif sur lequel il doit être rapporté, aussi bien que d'un retournement fiable sur celui-ci.

La présente invention a encore pour objet divers matériels propres à la mise en oeuvre d'un tel support individuel.

Il s'agit aussi bien du support collectif correspondant, qui est adapté à le recevoir au droit de ses ouvertures, que d'un poste de montage propre à faciliter la mise en place de la bague interne dans la structure annulaire externe, et que d'un poste de démontage de nature à faciliter au contraire le retrait de cette bague interne vis-à-vis de cette structure annulaire externe.

Les objets de l'invention, leurs caractéristiques et leurs avantages ressortiront d'ailleurs de la description qui va suivre, à titre d'exemple, en référence aux dessins schématiques annexés sur lesquels :

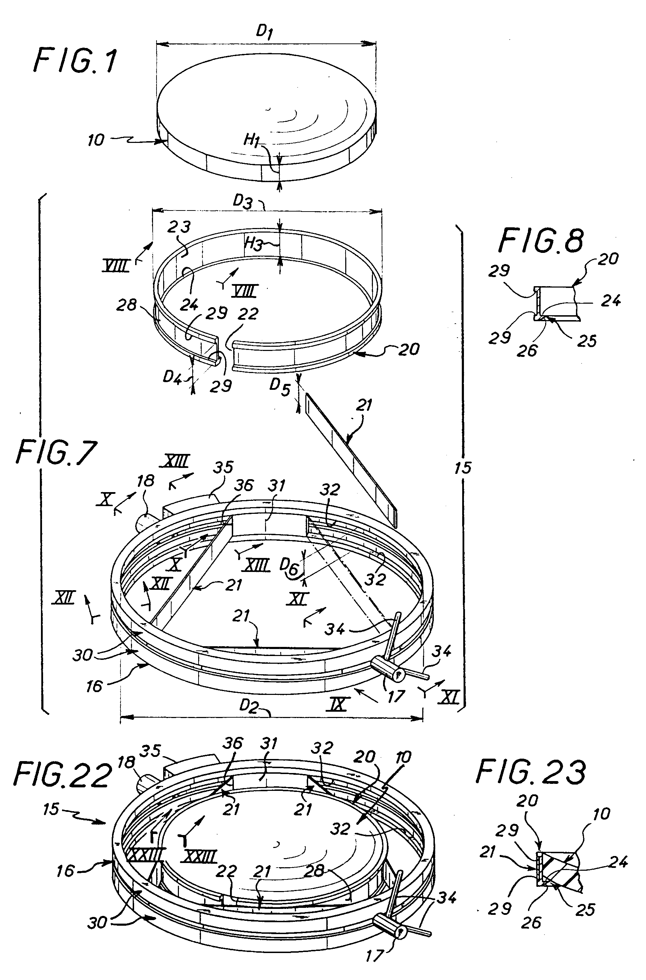

la figure 1 est une vue en perspective d'un substrat auquel est destiné le support individuel suivant l'invention ;
la figure 2 est une vue en perspective du support collectif sur lequel doit être rapporté ce support individuel ;
la figure 3 reprend, à échelle supérieure, le détail de la figure 2 repéré par un encart III sur cette figure 2 ;
la figure 4 est, à échelle encore supérieure, une vue partielle en coupe radiale de ce support collectif, suivant la ligne IV-IV de la figure 3 ;
les figures 5 et 6 en sont des vues partielles en élévation, suivant, chacune respectivement, les flèches V et VI de la figure 4 ;
la figure 7 est une vue en perspective éclatée du support individuel suivant l'invention ;
la figure 8 est une vue partielle en coupe radiale de la bague interne que comporte ce support individuel, suivant la ligne VIII-VIII de la figure 7 ;
la figure 9 est une vue en élévation de sa structure annulaire externe, suivant la flèche IX de la figure 7 ;
les figures 10, 11, 12 et 13 sont des vues partielles en coupe radiale de cette structure annulaire externe, suivant, chacune respectivement, les lignes X-X, XI-XI, XII-XII et XIII-XIII de la figure 7 ;
la figure 14 est une vue en coupe axiale d'un poste de montage propre à faciliter la mise en oeuvre du support individuel suivant l'invention, suivant la ligne XIV-XIV de la figure 15 ;
la figure 15 est une vue en plan de ce poste de montage, suivant la flèche XV de la figure 14 ;
la figure 16 est une vue en élévation d'un poste de démontage également propre à faciliter la mise en oeuvre du support individuel suivant l'invention, suivant la flèche XVI de la figure 17 ;
la figure 17 est une vue en plan de ce poste de démontage, suivant la flèche XVII de la figure 16 ;
les figures 18, 19A, 19B, 20, 21A et 21B sont des vues, soit en coupe, suivant celle de la figure 14, soit en plan, suivant celle de la figure 15, illustrant diverses phases successives de la mise en oeuvre du poste de montage ;
la figure 22 est une vue en perspective qui, reprenant celle des figures 1 et 7, se rapporte à un support individuel suivant l'invention lorsqu'il y a été mis en place un substrat à traiter ;
la figure 23 est une vue partielle en coupe radiale de l'ensemble correspondant, suivant la ligne XXIII-XXIII de la figure 22 ;
la figure 24 est une vue partielle en coupe radiale, qui, correspondant sensiblement à la ligne XXIV-XXIV de la figure 3, illustre l'intervention des moyens de commande assurant le retournement d'un support individuel suivant l'invention lorsqu'il est en place sur le support collectif correspondant ;
les figures 25A, 25B, 25C, 25D sont des vues schématiques en élévation, qui, correspondant globalement à la flèche XXV de la figure 24, illustrent chacune respectivement diverses phases successives du retournement correspondant.

Tel qu'illustré sur ces figures, il s'agit, globalement, d'assurer le maintien d'un quelconque substrat 10 lors de l'application à celui-ci d'un quelconque traitement.

Ce substrat 10 est par exemple un quelconque verre de lunettes, non débordé et non biseauté.

Il se présente donc sous la forme d'un palet, de contour périphérique globalement circulaire, et plus ou moins bombé.

Soit D1 le diamètre de son contour périphérique, et H1 son épaisseur le long de ce contour.

En pratique, le traitement en cause doit être successivement appliqué à l'une et l'autre des faces de ce substrat 10.

Pour ce faire, ce substrat 10 doit être rapporté sur un support collectif 11, en étant capable de retournement sur celui-ci.

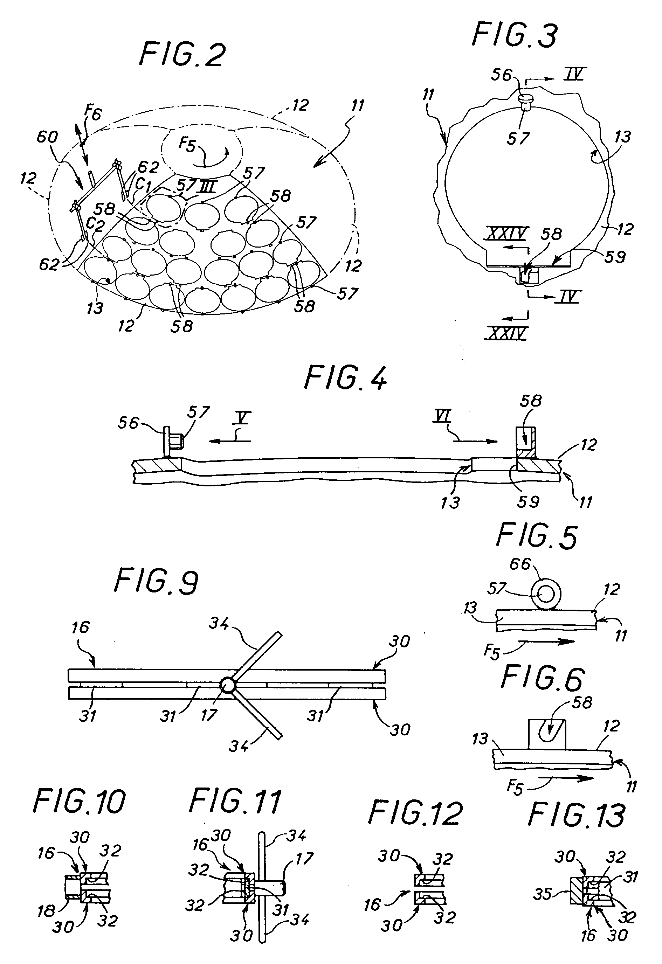

De manière connue en soi, ce support collectif 11, qui est schématisé à la figure 2, se présente sous la forme d'une calotte sphérique, en étant par exemple fractionné en une pluralité de plaques 12 distinctes.

Chacune de ces plaques 12 comporte elle-même une pluralité d'ouvertures 13 à la faveur de chacune desquelles peut être implanté un substrat 10 à traiter.

Dans la forme de réalisation représentée, ces ouvertures 13 sont disposées circulairement en quatre rangées, suivant un nombre qui va croissant radialement du centre vers la périphérie de l'ensemble.

De manière également connue en soi, la mise en place d'un substrat 10 dans une telle ouverture 13 se fait par l'intermédiaire d'un support individuel 15 comportant, d'une part, une structure annulaire 16, ou structure annulaire externe, qui, pour son montage pivotant sur le support collectif 11, est équipée, extérieurement, suivant un diamètre, de tourillons 17 et 18, et, d'autre part, suivant des modalités décrites plus en détail ultérieurement, des moyens d'assujettissement propres à permettre de rapporter sur cette structure annulaire externe 16 le substrat 10 à traiter.

Soit D2, largement supérieur à D1, le diamètre de cette structure annulaire externe 16.

Suivant l'invention, les moyens d'assujettissement propres à permettre d'y rapporter un substrat 10 à traiter comportent, d'une part, une bague 20, ou bague interne, qui, globalement concentrique de la structure annulaire externe 16, à l'intérieur de celle-ci, est propre à recevoir intérieurement, le substrat 10 à traiter, et, d'autre part, au moins deux languettes élastiquement déformables 21, qui, établies entre cette bague interne 20 et la structure annulaire externe 16, sont propres à son maintien dans cette dernière.

Préférentiellement, et tel que représenté, la bague interne 20 est ouverte radialement par une fente 22.

Soit D3 son diamètre au repos.

Ce diamètre D3 est sensiblement égal au diamètre D1 du substrat 10 à traiter.

Dans la forme de réalisation représentée, la surface interne 23 de la bague interne 20 est cylindrique.

En outre, dans cette forme de réalisation, la bague interne 20 présente, radialement en saillie sur cette surface interne 23, pour butée du substrat 10 à traiter, un épaulement annulaire 24 qui s'étend transversalement par rapport à son axe.

Soit H3 la hauteur de la surface interne 23 à compter de cet épaulement annulaire 24.

Préférentiellement, mais non obligatoirement, cette hauteur H3 est supérieure à l'épaisseur H1 du substrat 10 le long de son contour périphérique.

Quoi qu'il en soit, l'épaulement annulaire 24 appartient à un retour en équerre 25 dont, préférentiellement, et tel que représenté, la surface externe 26 est biseautée.

Enfin, la bague interne 20 présente radialement en saillie, sur sa surface externe 28, à distance l'un de l'autre, deux épaulements annulaires 29, qui s'étendent transversalement par rapport à son axe, et entre lesquels s'étendent, dans le sens de leur largeur, les languettes élastiquement déformables 21.

Autrement dit, la distance D4 séparant l'un de l'autre ces épaulements annulaires 29 est sensiblement égale à la largeur D5 des languettes élastiquement déformables 21 tout en étant légèrement supérieure à celle-ci.

La bague interne 20 ainsi constituée est par exemple en métal, et, plus précisément, en acier inoxydable.

A la différence de cette bague interne 20, la structure annulaire externe 16 est, dans la forme de réalisation représentée, circulairement fermée.

Préférentiellement, et tel que représenté, cette structure annulaire externe 16 est ajourée, pour favoriser le passage d'un quelconque liquide de lavage lorsque le traitement à appliquer au substrat 10 à traiter implique l'exécution préalable, et/ou ultérieure, d'une telle phase de lavage.

Dans la forme de réalisation représentée, la structure annulaire externe 16 est, pour ce faire, formée de deux anneaux 30, qui, écartés l'un de l'autre, sont de place en place reliés l'un à l'autre par des entretoises 31, les ajours correspondants résultant des interstices subsistant entre ces anneaux 30 et ces entretoises 31.

En pratique, les anneaux 30 ainsi constitutifs de la structure annulaire externe 16 sont identiques l'un à l'autre, ils ont radialement une section en L, et ils sont disposés tête-bêche l'un par rapport à l'autre.

Il en résulte que la structure annulaire externe 16 présente radialement en saillie, à distance l'un de l'autre sur sa surface interne, deux épaulements annulaires 32, qui s'étendent transversalement par rapport à son axe.

Soit D6 la distance séparant l'un de l'autre ces épaulements annulaires 32.

Cette distance D6 est sensiblement égale à la largeur D5 des languettes élastiquement déformables 21, tout en étant légèrement supérieure à celle-ci.

Dans la forme de réalisation représentée, les entretoises 31 interviennent sur la surface interne de la structure annulaire externe 16, en s'étendant de l'un à l'autre de ses épaulements annulaires 32.

En outre, dans cette forme de réalisation, ces entretoises 31 sont au nombre de trois, et elles sont régulièrement réparties circulairement, à 120° deux à deux, autour de l'axe de l'ensemble.

Suivant l'invention, les tourillons 17 et 18 dont est équipée la structure annulaire externe 16 ainsi constituée sont différenciés, pour former détrompeurs.

Par exemple, et tel que représenté, l'un d'eux, en l'espèce le tourillon 17, est formé par un simple goujon, destiné à constituer un axe, tandis que l'autre, en l'espèce le tourillon 18, est formé par une douille, destinée à constituer un moyeu.

Les moyens de commande dont est également équipée la structure annulaire externe 16 pour en permettre le retournement à la volée par pivotement autour de ses tourillons 17, 18 comportent, suivant l'invention, deux doigts 34, qui s'étendent chacun respectivement en oblique, suivant par exemple un angle de l'ordre de 45°, de part et d'autre du plan de cette structure annulaire externe 16.

Dans la forme de réalisation représentée, ces doigts 34 s'étendent à compter du tourillon 17, en s'enracinant à celui-ci au voisinage de la surface externe de la structure annulaire externe 16.

Enfin, dans la forme de réalisation représentée, la structure annulaire externe 16 est également équipée d'une masselotte 35 qui, par rapport au diamètre suivant lequel sont disposés les tourillons 17 et 18, s'étend du même côté de ce diamètre que les doigts 34.

Dans la forme de réalisation représentée, cette masselotte 35 intervient en saillie sur la surface externe de la structure annulaire externe 16.

Comme la bague interne 20, la structure annulaire externe 16 ainsi constituée peut aussi être par exemple réalisée en métal, et, plus précisément, en acier inoxydable.

Quant aux languettes élastiquement déformables 21, il s'agit de lames de ressort, et elles sont donc elles aussi réalisées par exemple en métal, et, plus précisément, en bronze-berylium.

Dans la forme de réalisation représentée, trois languettes élastiquement déformables 21 sont mises en oeuvre, en étant sensiblement disposées sur les côtés d'un triangle.

Chacune d'elles s'étend librement, d'une part, dans le sens de la longueur, entre deux épaulements 36, ou épaulements axiaux, que la structure annulaire externe 16 présente à cet effet parallèlement à son axe, en saillie sur sa surface interne, et, d'autre part, dans le sens de la largeur, entre les deux épaulements annulaires 32 que présente conjointement radialement en saillie sur cette surface interne cette structure annulaire externe 16.

En pratique, les épaulements axiaux 36 de la structure annulaire externe 16 appartiennent à ses entretoises 31, en étant formés par les tranches d'extrémité de celles-ci.

Les languettes élastiquement déformables 21 sont donc en simple appui, dans le sens de leur longueur, sur ces entretoises 31, en étant retenues, dans le sens de leur largeur, par les épaulements annulaires 32.

Globalement, ces languettes élastiquement déformables 21 s'étendent suivant des cordes pour la structure annulaire externe 16, et suivant des tangentes pour la bague interne 20, en étant prises, au passage, dans le sens de leur largeur, entre les épaulements annulaires 29 de cette dernière.

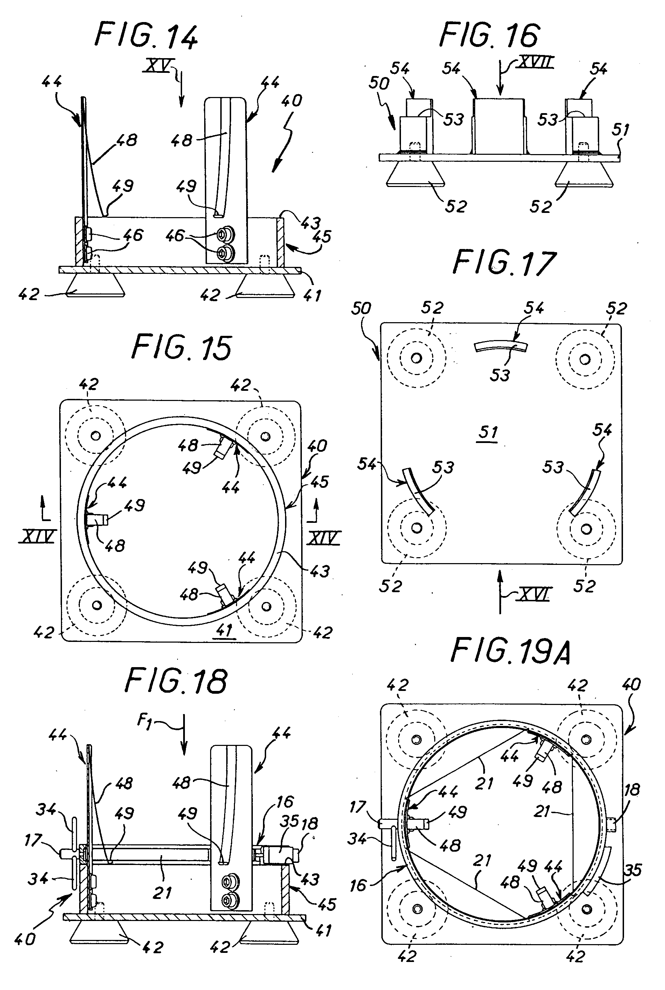

Les figures 14 à 17 se rapportent à du matériel susceptible de faciliter la mise en oeuvre du support individuel retournable 15 ainsi constitué.

Il s'agit, tout d'abord, pour la mise en place de la bague interne 20 dans la structure annulaire externe 16, d'un poste de montage 40, figures 14 et 15.

Outre une platine 41 équipée de pieds 42, ce poste de montage 40 comporte, d'une part, annulairement, un épaulement 43, sur lequel doit être posée la structure annulaire externe 16, et, d'autre part, répartis circulairement autour de l'axe de cet épaulement 43, à l'intérieur de celui-ci, et parallèlement à cet axe, autant de jambages 44 qu'il y a de languettes élastiquement déformables 21, pour déformation élastique vers l'extérieur de celles-ci lorsque, la structure annulaire externe 16 étant pivotée autour de l'axe de l'épaulement 43, elles s'engagent, chacune respectivement, derrière ces jambages 44.

Dans la forme de réalisation représentée, l'épaulement 43 appartient à une couronne circulairement continue 45 portée par la platine 41, en étant en pratique formé par la tranche libre de cette couronne 45, il y a, répartis circulairement, à 120° deux à deux, trois jambages 44, qui, chacun individuellement, sont rapportés par des vis 46 sur la surface interne de la couronne 45 et, pour la retenue de la bague interne 20, chacun de ces jambages 44 porte, sur sa face interne, une lamelle élastiquement déformable 48, qui s'étend librement à compter de la partie haute d'un tel jambage 44, globalement parallèlement à celui-ci, en s'écartant au repos de ce jambage 44 en direction de l'axe de la couronne 45, et donc en direction de l'axe de l'épaulement 43, et qui, à son extrémité libre, présente, également en direction de cet axe, un retour en équerre 49.

Dans un premier temps, la structure annulaire externe 16 est engagée sur les jambages 44, à l'extérieur de ceux-ci, suivant la flèche F1 de la figure 18, jusqu'à venir reposer, tel que représenté sur cette figure 18 et sur la figure 19A, sur l'épaulement 43 formé par la couronne 45, dont le diamètre a été prévu suffisant à cet effet.

Les languettes élastiquement déformables 21 s'étendent alors, de manière sensiblement rectiligne, à l'écart des jambages 44.

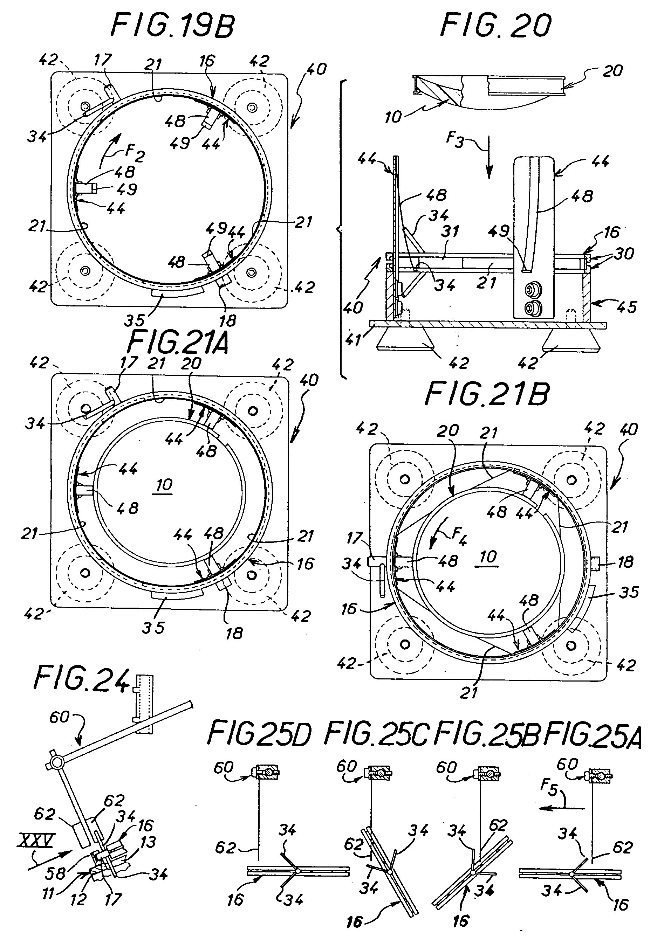

Dans un deuxième temps, il est procédé à une rotation de 60° de la structure annulaire externe 16, tel que schématisé par la flèche F2 sur la figure 19B, ce qui conduit les languettes élastiquement déformables 21 à s'engager derrière les jambages 44, en étant dès lors contraintes par ceux-ci à se déformer annulairement.

Dans un troisième temps, la bague interne 20, dûment refermée sur la tranche du substrat 10 à traiter, est engagée entre les jambages 44, tel que schématisé par la flèche F3 sur la figure 20, jusqu'à venir reposer sur les retours en équerre 49 des lamelles élastiquement déformables 48 portées par ceux-ci, tel que représenté à la figure 21A.

Il suffit, dès lors, dans un quatrième temps, suivant un mouvement de rotation inverse du précédent, et tel que schématisé par la flèche F4 sur la figure 21B, de ramener la structure annulaire externe 16 à sa position initiale, pour que, dûment libérées par les jambages 44, les languettes élastiquement déformables 21 viennent chacune en prise avec la bague interne 20, en s'engageant entre les deux épaulements annulaires 29 de celle-ci.

La structure annulaire externe 16, ainsi équipée de la bague interne 20, et donc du substrat 10 à traiter, peut ensuite être retirée du poste de montage 40.

Sur les figures 16 et 17, il s'agit d'un poste de démontage 50, propre à faciliter le dégagement de la bague interne 20 de la structure annulaire externe 16 sans chute des languettes élastiquement déformables 21.

Outre une platine 51 équipée de pieds 52, ce poste de démontage 50 comporte, répartis circulairement autour d'un axe, autant de jambages 54 qu'il y a de languettes élastiquement déformables 21, avec, à un même niveau sur chacun de ces jambages 54, en décrochement sur leur surface externe, un épaulement 53 transversal par rapport à cet axe.

En pratique, et comme précédemment, il y a, répartis régulièrement circulairement, à 120° deux à deux, trois jambages 54.

Il suffit de placer la structure annulaire externe 16 sur leurs épaulements 53, puis de la faire tourner sur elle-même de 60° dans son plan, pour que, s'engageant derrière la partie des jambages 54 située au-delà de ces épaulements 53, et contraintes ainsi, comme précédemment, de se déformer annulairement, les languettes élastiquement déformables 21 libèrent la bague interne 20.

L'espace subsistant entre les jambages 54 permet de la retenir à la main, puis de la retirer de la structure annulaire externe 16.

Quant au support collectif 11, il présente, en bordure de chacune de ses ouvertures 13, pour le montage pivotant d'un support individuel 15 dans celle-ci, d'une part, porté par une plaquette 56, un ergot 57, sur lequel peut être engagée à tourillonnement la douille constituant le tourillon 18 de ce support individuel 15, et, d'autre part, diamétralement en regard de cet ergot 57, un berceau 58, qui est apte à recevoir à tourillonnement le goujon formant l'autre tourillon 17 de ce support individuel 15.

Dans la forme de réalisation représentée, le berceau 58 s'étend en bordure d'une échancrure 59, à fond droit, prolongeant localement l'ouverture 13.

En outre, dans cette forme de réalisation, le support collectif 11 étant susceptible d'être entraîné en rotation sur lui-même autour de son axe, dans le sens de rotation repéré par la flèche F5 des figures 2, 5, 6 et 25A, le berceau 58 s'étend en oblique par rapport au plan de l'ouverture 13, en se rapprochant de ce plan de son débouché à son fond dans le sens contraire à ce sens de rotation.

D'une rangée à l'autre, les ouvertures 13 d'une même plaque 12 du support collectif 11 sont disposées tête-bêche, de manière à ce que, tel que schématisé en traits interrompus C1 et C2 sur la figure 2, les berceaux 58 de deux de ses rangées circulent suivant globalement un même trajet circulaire C1, tandis que ceux des deux autres rangées circulent eux-mêmes suivant globalement un même trajet circulaire C2.

Au support collectif 11, il est associé un étrier 60, qui, disposé globalement radialement par rapport à ce support collectif 11, est susceptible d'être abaissé ou remonté par rapport à celui-ci, tel que schématisé par la double flèche F6 sur la figure 2, et qui, au droit de chacun des trajets circulaires C1, C2 précédents, présente, dos à dos, deux boucles 62.

Après une première phase de traitement, au cours de laquelle, le support collectif 11 étant commandé en rotation, une première des faces des substrats 10 portés par ce support collectif 11 a dûment été traitée, la vitesse de rotation du support collectif 11 est réduite, et l'étrier 60 est suffisamment abaissé pour que ses boucles 62 soient interposées sur celui des doigts 34 des supports individuels 15 qui fait alors saillie sur le plan de ceux-ci.

Ainsi, lors de la rotation à vitesse réduite du support collectif 11, les doigts 34 correspondants des supports individuels 15 s'engagent à tour de rôle dans la boucle 62 correspondante de cet étrier 60, ce qui provoque progressivement le retournerment à la volée de chacun de ces supports individuels 15, par pivotement autour des tourillons 17 et 18 de leur structure annulaire externe 16, tel que schématisé pour l'un d'eux sur les figures 25A, 25B, 25C et 25D.

Si, de manière fortuite, le retournement d'un support individuel 15 n'était pas total, une deuxième rotation du support collectif 11 en assure l'achèvement, l'étrier 60 intervenant alors sur l'autre de ses doigts 34.

Dans tous les cas, la masselotte 35 fait butée, ce qui suffit à définir la position des supports individuels 15 par rapport au support collectif 11, et, ainsi qu'on le comprendra, le débattement, par rapport au support collectif 11, des doigts 34 d'un support individuel 15 lors du retournement de celui-ci se fait à la faveur de l'échancrure 59 prolongeant localement l'ouverture 13 correspondante de ce support collectif 11.

Quel que soit le diamètre D1 des substrats 10 à traiter, la structure annulaire externe 16 de ces supports individuels 15 est la même pour tous, suivant le support collectif 11 utilisé.

Seule change, suivant le diamètre des substrats 10, leur bague interne 20.

Enfin, et ainsi qu'on l'aura compris, l'inclinaison des berceaux 58 du support collectif 11 permet avantageusement d'éviter un déjantage des supports individuels 15 lors de leur retournement.

Bien entendu, la présente invention ne se limite cependant pas aux formes de réalisation décrites et représentées, mais englobe toute variante d'exécution.

## Revendications

1. Support individuel pour substrat de contour périphérique globalement circulaire à l'une et l'autre des faces duquel doit être successivement appliqué un traitement, du genre comportant, d'une part, une structure annulaire (16), dite ci-après structure annulaire externe, qui, pour son montage pivotant sur un support collectif (11), est équipée extérieurement de tourillons (17, 18), et, d'autre part, des moyens d'assujettissement propres à permettre de rapporter sur cette structure annulaire externe (16) le substrat (10) à traiter, caractérisé en ce que lesdits moyens d'assujettissement comportent, d'une part, une bague (20), ou bague interne, qui, globalement concentrique de la structure annulaire externe (16), est propre à recevoir intérieurement le substrat (10) à traiter, et, d'autre part, au moins deux languettes élastiquement déformables (21), qui, établies entre ladite bague interne (20) et la structure annulaire externe (16), sont propres à son maintien dans cette dernière.

2. Support individuel suivant la revendication 1, caractérisé en ce que la bague interne (20) est ouverte radialement par une fente (22).

3. Support individuel suivant l'une quelconque des revendications 1, 2, caractérisé en ce que la structure annulaire externe (16) est circulairement fermée.

4. Support individuel suivant l'une quelconque des revendications 1 à 3, caractérisé en ce que, la bague interne (20) présentant radialement en saillie sur sa surface interne (23), pour butée du substrat (10) à traiter, un épaulement annulaire (24), ledit épaulement annulaire (24) appartient à un retour en équerre (25) dont la surface externe (26) est biseautée.

5. Support individuel suivant l'une quelconque des revendications 1 à 4, caractérisé en ce que, globalement, les languettes élastiquement déformables (21) s'étendent suivant des cordes pour la structure annulaire externe (16) et suivant des tangentes pour la bague interne (20).

6. Support individuel suivant l'une quelconque des revendications 1 à 5, caractérisé en ce que la bague interne (20) présente radialement en saillie sur sa surface externe (28), à distance l'un de l'autre, deux épaulements annulaires (29) entre lesquels s'étendent les languettes élastiquement déformables (21).

7. Support individuel suivant l'une quelconque des revendications 1 à 6, caractérisé en ce que chacune des languettes élastiquement déformables (21) s'étend librement, d'une part, entre deux épaulements (36), ou épaulements axiaux, que la structure annulaire externe (16) présente parallèlement à son axe, et, d'autre part, entre deux épaulements annulaires (32) que la structure annulaire externe (16) présente radialement en saillie à distance l'un de l'autre sur sa surface interne.

8. Support individuel suivant l'une quelconque des revendications 1 à 7, caractérisé en ce qu'il y a globalement en triangle trois languettes élastiquement déformables (21).

9. Support individuel suivant l'une quelconque des revendications 1 à 8, caractérisé en ce que la structure annulaire externe (16) est ajourée.

10. Support individuel suivant la revendication 7, caractérisé en ce que la structure annulaire externe (16) est formée de deux anneaux (30), qui, écartés l'un de l'autre, sont de place en place reliés l'un à l'autre par des entretoises (31).

11. Support individuel suivant les revendications 7 et 10, prises conjointement, caractérisé en ce que les épaulements axiaux (36) entre lesquels s'étendent les languettes élastiquement déformables (21) appartiennent auxdites entretoises (31).

12. Support individuel suivant l'une quelconque des revendications 1 à 11, caractérisé en ce que les anneaux (30) constitutifs de la structure annulaire externe (16) ont radialement une section en L.

13. Support individuel suivant l'une quelconque des revendications 1 à 12, caractérisé en ce que les tourillons (17, 18) de la structure annulaire externe (16) sont différenciés, l'un d'eux étant formé par un goujon et l'autre par une douille.

14. Support individuel suivant l'une quelconque des revendications 1 à 13, caractérisé en ce que, des moyens de commande étant prévus sur sa structure annulaire externe (16) pour en permettre le retournement à la volée par pivotement autour de ses tourillons (17, 18), lesdits moyens de commande comportent deux doigts (34) qui s'étendent chacun respectivement en oblique de part et d'autre du plan de cette structure annulaire externe (16).

15. Matériel propre à la mise en oeuvre d'un support individuel (15) suivant l'une quelconque des revendications 1 à 14, caractérisé en ce que, s'agissant d'un support collectif (11) présentant une pluralité d'ouvertures (13) dans chacune desquelles doit être monté retournable un tel support individuel (15), avec, en bordure d'une telle ouverture (13), pour le montage pivotant de ce support individuel (15), un berceau (58), ledit berceau (58) s'étend en oblique par rapport au plan de ladite ouverture (13).

16. Matériel propre à la mise en oeuvre d'un support individuel suivant l'une quelconque des revendications 1 à 14, caractérisé en ce qu'il s'agit d'un poste de montage (40), qui, pour la mise en place de la bague interne (20) d'un tel support individuel (15) dans sa structure annulaire externe (16), comporte, d'une part, annulairement, un épaulement (43) sur lequel doit être posée ladite structure annulaire externe (16), et, d'autre part, répartis circulairement autour de l'axe de cet épaulement (43), à l'intérieur de celui-ci, et parallèlement audit axe, autant de jambages (44) qu'il y a de languettes élastiquement déformables (21), pour déformation élastique vers l'extérieur de celles-ci lorsque, la structure annulaire externe (16) étant pivotée autour dudit axe, elles s'engagent, chacune respectivement, derrière lesdits jambages (44).

17. Matériel suivant la revendication 16, caractérisé en ce que, pour retenue de la bague interne (20), chacun des jambages (44) porte, sur sa face interne, une lamelle élastiquement déformable (48), qui s'étend librement à compter dudit jambage (44), parallèlement à celui-ci, en s'écartant au repos de ce jambage (44), et qui, à son extrémité libre, présente, en direction de l'axe de l'épaulement (43), un retour en équerre (49).

18. Matériel suivant l'une quelconque des revendications 16, 17, caractérisé en ce que l'épaulement (43) appartient à une couronne (45) circulairement continue.

19. Matériel propre à la mise en oeuvre d'un support individuel suivant l'une quelconque des revendications 1 à 14, caractérisé en ce qu'il s'agit d'un poste de démontage (50) comportant, répartis circulairement autour d'un axe, autant de jambages (54) qu'il y a de languettes élastiquement déformables (21), avec, à un même niveau sur chacun de ces jambages (54), en décrochement sur leur surface externe, un épaulement (53) transversal par rapport audit axe.

## Claims

1. An individual support for a substrate of overall circular peripheral contour, both faces of which are to be subjected to a treatment successively, of the kind comprising an annular structure (16), on the one hand, hereinafter called the outer annular structure, which, in order to be pivotally mounted to a composite support (11), is provided externally with journals (17, 18), and comprising fastening means, on the other hand, to enable the substrate (10) to be treated to be connected to the outer annular structure (16), characterised in that said fastening means comprise a ring (20) or inner ring, on the one hand, which is overall concentric with the outer annular structure (16) and which is capable of internally receiving the substrate (10) to be treated, and comprising at least two elastically deformable tongue portions (21), on the other hand, which are formed between said inner ring (20) and the outer annular structure (16) and which are capable of holding the inner ring in this latter.

2. An individual support according to Claim 1, characterised in that the inner ring (20) is open radially by a slit (22).

3. An individual support according to any one of Claims 1, 2, characterised in that the outer annular structure (16) is circularly closed.

4. An individual support according to any one of Claims 1 to 3, characterised in that the inner ring (20) has an annular shoulder (24) projecting radially from its inner surface (23) and which acts as an abutment for the substrate (10) to be treated, said annular shoulder (24) being associated with an offset return portion (25) whose outer surface (26) is bevelled.

5. An individual support according to any one of Claims 1 to 4, characterised in that overall the elastically deformable tongue portions (21) extend along chords as far as the outer annular structure (16) is concerned and along tangents as far as the inner ring (20) is concerned.

6. An individual support according to any one of Claims 1 to 5, characterised in that the inner ring (20) has two annular shoulders (29) which project radially over the outer edge (28) at a spacing apart from each other, between which shoulders elastically deformable tongue portions (21) extend.

7. An individual support according to any one of Claims 1 to 6, characterised in that each of the elastically deformable tongue portions (21) extends freely between two shoulders (36), or axial shoulders, on the one hand, which the outer annular structure (16) has parallel to its axis, and between two annular shoulders (32), on the other hand, which the outer annular structure (16) has which project radially over its inner surface at a spacing apart from each other.

8. An individual support according to any one of Claims 1 to 7, characterised in that there are overall three elastically deformable tongue portions (21) forming a triangular configuration.

9. An individual support according to any one of Claim 1 to 8, characterised in that the outer annular structure (16) is provided with holes.

10. An individual support according to Claim 7, characterised in that the outer annular structure (16) is formed by two rings (30) which are spaced apart and are connected to each other from place to place by a distancing sleeve (31).

11. An individual support according to Claims 7 and 10 taken conjointly, characterised in that the axial shoulders (36) between which the elastically deformable tongue portions (21) extend are associated with said distancing sleeves (31).

12. An individual support according to any one of Claims 1 to 11, characterised in that the rings (30) which form the outer annular structure (16) are of L-shaped section radially.

13. An individual support according to any one of Claims 1 to 12, characterised in that the journals (17, 18) of the outer annular structure (16) are different, one of them being formed by a pin and the other being formed by a sleeve.

14. An individual support according to any one of Claims 1 to 13, characterised in that control means are provided on its outer annular structure (16) to enable it to be turned over, at random, by pivoting about its journals (17, 18), said control means comprising fingers (34) which each respectively extend inclinedly on either side of the plane of this outer annular structure (16).

15. A piece of equipment capable of being used for an individual support (15) according to any one of Claims 1 to 14, characterised in that in the case of a composite support (11) having a plurality of openings (13) into each of which an individual support (15) of this kind has to be mounted in such a way that it can be turned over, with a cradle (58) at the edge of such an opening (13) to provide for pivotal mounting of this individual support (15), said cradle (58) extends inclinedly with respect to the plane of said opening (13).

16. A piece of equipment capable of being used for an individual support according to any one of Claims 1 to 14, characterised in that it is an assembly post (40), which, for positioning the inner ring (20) of an individual support (15) of this kind in its outer annular structure (16) has an annular shoulder (43), on the one hand, on which said outer annular structure (16) has to be placed, and, on the other hand, has legs (44) which are distributed circularly about the axis of this shoulder (43), inside that shoulder, and parallel to said axis, and being equal in number to the elastically deformable tongue portions (21), to elastically deform these tongue portions outwardly when they each respectively engage behind said legs (44) when the outer annular structure (16) is pivoted about said axis.

17. A piece of equipment according to Claim 16, characterised in that to hold the inner ring (20) in place, each of the legs (44) has on its inner face an elastically deformable vane (48) which extends freely from said leg (44), parallel thereto, moving away from that leg (44) when at rest, and, at its free end having a return portion (49) which is offset in the direction of the axis of the shoulder (43).

18. A piece of equipment according to any one of Claims 16, 17, characterised in that the shoulder (43) is associated with a circularly continuous rim (45).

19. A piece of equipment capable of being used for an individual support according to any one of Claims 1 to 14, characterised in that it is a release post (50) which comprises legs (54) which are distributed circularly about an axis and which are equal in number to the number of elastically deformable tongue portions (21), with a shoulder (53) being provided which is transverse to said axis and at the same level on each of the legs (54) and being hooked over their outer surface.

## Patentansprüche

1. Einzelner Halter für ein Substrat mit im wesentlichen kreisförmiger Umfangskontur, auf dessen einer und der anderen der Flächen nacheinander eine Behandlung durchgeführt werden soll, der Art, welche einerseits eine ringförmige Struktur (16), welche nachfolgend äußere ringförmige Struktur genannt wird, welche für eine schwenkbare Festlegung an eine gemeinsamen Halter (11) außen mit Drehzapfen (17, 18) ausgestattet ist, und andererseits eine Befestigungseinrichtung umfaßt, welche geeignet ist, die Anordnung des zu behandelnden Substrate (10) an der äußeren ringförmigen Struktur (16) zu ermöglichen, dadurch gekennzeichnet, daß die Befestigungseinrichtung einerseits einen Ring (20) oder inneren Ring, welcher im wesentlichen konzentrisch zur äußeren ringförmigen Struktur (16) für eine Aufnahme des zu behandelnden Substrate (10) im Inneren geeignet ist, und andererseits wenigstens zwei elastisch verformbare Laschen (21) umfaßt, welche, zwischen dem inneren Ring (20) und der äußeren ringförmigen Struktur (16) angeordnet, für sein Halten in der letzteren geeignet sind.

2. Einzelner Halter nach Anspruch 1, dadurch gekennzeichnet, daß der innere Ring (20) in radialer Richtung durch einen Schlitz (22) geöffnet ist.

3. Einzelner Halter nach eine der Ansprüche 1 oder 2, dadurch gekennzeichnet, daß die äußere ringförmige Struktur (16) kreisförmig geschlossen ist.

4. Einzelner Halter nach einem der Ansprüche 1 bis 3, dadurch gekennzeichnet daß der innere Ring (20) radial von seiner inneren Oberfläche (23) vorspringend als Anschlag für das zu behandelnde Substrat (10) eine ringförmige Schulter (24) aufweist, wobei die ringförmige Schulter (24) zu einem Winkel (25) gehört, dessen äußere Oberfläche (26) abgeschrägt ist.

5. Einzelner Halter nach einem der Ansprüche 1 bis 4, dadurch gekennzeichnet, daß die elastisch verformbaren Laschen (21) sich im wesentlichen entlang von Sehnen für die äußere ringförmige Struktur (16) und entlang von Tangenten für den inneren Ring (20) erstrecken.

6. Einzelner Halter nach einem der Ansprüche 1 bis 5, dadurch gekennzeichnet, daß der innere Ring (20) radial von seiner äußeren Oberfläche (28) vorspringend in Abstand voneinander zwei ringförmige Schultern (29) aufweist, zwischen welchen sich die elastisch verformbaren Laschen (21) erstrecken.

7. Einzelner Halter nach einem der Ansprüche 1 bis 6, dadurch gekennzeichnet, daß sich jede der elastisch verformbaren Laschen (21) frei einerseits zwischen zwei Schultern (36) oder achsialen Schultern, welche die äußere ringförmige Struktur (16) parallel zu ihrer Achse aufweist, und andererseits zwischen zwei ringförmigen Schultern (37) erstreckt, welche die äußere ringförmige Struktur (16) radial vorspringend in Abstand voneinander an ihrer inneren Oberfläche aufweist.

8. Einzelner Halter nach einem der Ansprüche 1 bis 7, dadurch gekennzeichnet, daß im wesentlichen in einem Dreieck drei elastisch verformbare Laschen (21) vorgesehen sind.

9. Einzelner Halter nach einem der Ansprüche 1 bis 8, dadurch gekennzeichnet, daß die äußere ringförmige Struktur (16) durchbrochen ist.

10. Einzelner Halter nach Anspruch 7, dadurch gekennzeichnet, daß die äußere ringförmige Struktur (16) von zwei Ringen (30) gebildet ist, welche voneinander beabstandet an mehreren Stellen durch Stege (31) miteinander verbunden sind.

11. Einzelner Halter nach den Ansprüchen 7 und 10, dadurch gekennzeichnet, daß die achsialen Schultern (36), zwischen weichen sich die elastisch verformbaren Laschen (21) erstrecken, zu den Stegen (31) gehören.

12. Einzelner Halter nach einem der Ansprüche 1 bis 11, dadurch gekennzeichnet, daß die die äußere ringförmige Struktur (16) bildenden Ringe (30) in radialer Richtung einen L-förmigen Querschnitt aufweisen.

13. Einzelner Halter nach einem der Ansprüche 1 bis 12, dadurch gekennzeichnet, daß die Drehzapfen (17, 18) der äußeren ringförmigen Struktur (16) verschieden sind, wobei einer derselben als Bolzen und der andere als Buchse ausgebildet ist.

14. Einzelner Halter nach einem der Ansprüche 1 bis 13, dadurch gekennzeichnet, daß eine Steuereinrichtung an seiner äußeren ringförmigen Struktur (16) vorgesehen ist, um das Kippen durch Verschwenken um ihre Drehzapfen (17, 18) zu ermöglichen, wobei die Steuereinrichtung zwei Finger (34) umfaßt, welche sich jeweils geneigt zu beiden Seiten der Ebene dieser äußeren ringförmigen Struktur (16) erstrecken.

15. Anlage zur Anwendung eines einzelnen Halters (15) nach einem der Ansprüche 1 bis 14, dadurch gekennzeichnet, daß es sich um einen gemeinsamen Halter (11), welcher eine Vielzahl von Öffnungen (13) aufweist, wobei in jeder derselben wendbar ein derartiger einzelner Halter (15) angeordnet werden muß, mit einem Bogen (58) am Rand einer derartigen Öffnung (13) für die schwenkbare Festlegung diesem einzelnen Halters handelt, wobei sich der Bogen (58) geneigt relativ zur Ebene dieser Öffnung (13) erstreckt.

16. Anlage zur Anwendung eines einzelnen Halters nach einem der Ansprüche 1 bis 14, dadurch gekennzeichnet, daß es sich um einen Montagestand (40) handelt, welcher für die Anordnung des inneren Ringes (20) eines derartigen einzelnen Halters (15) in seiner äußeren ringförmigen Struktur (16) einerseits ringförmig eine Schulter (43), auf welcher die äußere ringförmige Struktur (16) angeordnet werden muß, und andererseits kreisförmig um die Achse dieser Schulter (43) verteilt im Inneren derselben und parallel zu dieser Achse ebenso viele Stützen (44), wie elastisch verformbare Laschen (21) vorhanden sind, zum elastischen Verformen derselben nach außen umfaßt, wobei diese bei einem Verschwenken der äußeren ringförmigen Struktur (16) um diese Achse jeweils hinter den Stützen (44) in Eingriff gelangen.

17. Anlage nach Anspruch 16, dadurch gekennzeichnet, daß für ein Zurückhalten des inneren, Ringes (20) jede der Stützen (44) an ihrer Innenfläche ein elastisch verformbares Blättchen (48) aufweist, welches sich frei ausgehend von der Stütze (44) parallel zu dieser und voll der Lagerung der Stütze (44) beabstandet erstreckt und welches an seinem freien Ende in Richtung zur Achse der Schulter (43) einen abgewinkelten Vorsprung (49) aufweist.

18. Anlage nach einem der Ansprüche 16 oder 17, dadurch gekennzeichnet, daß die Schulter (43) zu einem kontinuierlichen kreisförmigen Kranz (45) gehört.

19. Anlage zur Anwendung eines einzelnen Halters nach einem der Ansprüche 1 bis 14, dadurch gekennzeichnet, daß es sich um einen Demontagestand (50) handelt, welcher kreisförmig um seine Achse verteilt ebenso viele Stützen (54), wie elastisch verformbare Laschen (21) aufweist, mit einer auf einer jeweils gleichen Höhe an jeder der Stutzen (54) von ihrer äußeren Oberfläche losgelösten und einer normal relativ zu dieser Achse verlaufenden Schulter (53) umfaßt.
